# EUROPÄISCHE PATENTSCHRIFT

(11) **EP 1 157 260 B1**
(45) Veröffentlichungstag und Bekanntmachung des Hinweises auf die Patenterteilung: **10.09.2003**
(21) Anmeldenummer: 00909012.7
(22) Anmeldetag: 08.02.2000
(51) Int. Cl.: G01J 1/44

(54) **LICHTSENSOR**
LIGHT SENSOR
CAPTEUR DE LUMIERE

(30) Priorität: 24.02.1999 DE 19907970
(43) Veröffentlichungstag der Anmeldung: 28.11.2001
(73) Patentinhaber: ROBERT BOSCH GMBH, 70442 Stuttgart (DE)
(72) Erfinder: HENNO, Christiane, D-72070 Tübingen (DE); BAUER, Roger, D-72762 Reutlingen (DE); METTLER, Stephan, D-72766 Reutlingen (DE)
(86) Internationale Anmeldenummer: DE0000375
(87) Internationale Veröffentlichungsnummer: WO00050858

(56) Entgegenhaltungen:
- DE-A- 4 209 536
- US-A- 4 555 623
- US-A- 5 091 640

## Beschreibung

Die Erfindung betrifft einen Lichtsensor mit einem Phototransistor und einem Impedanzwandler für ein Potential einer Hauptelektrode des Phototransistor gemäß dem Oberbegriff des Anspruchs 1. Ein solcher Lichtsensor ist zum Beispiel aus DE 4 209 536 bekannt.

Bei diesem bekannten Lichtsensor ist die Steuerelektrode des Phototransistors zusammen mit dessen zweiter Hauptelektrode an ein erstes Versorgungspotential des Lichtsensors angeschlossen.

Bei diesem Lichtsensor ist der Phototransistor in schwacher Inversion betrieben, was ihm eine lineare Ausgangskennlinie des Photostroms beziehungsweise eine logarithmische Ausgangskennlinie der Photospannung in Abhängigkeit von der empfangenen Beleuchtungsstärke verleiht. Derartige Sensoren sind vorteilhaft, da sie die übersteuerungsfreie Erfassung von Beleuchtungsstärken über mehrere Dekaden hinweg ermöglichen und dadurch gut geeignet sind für Bilderfassungsanwendungen, zum Beispiel in der Kraftfahrzeugtechnik, wo Bilder verarbeitet werden müssen, die extrem starke Helligkeitsunterschiede aufweisen, so zum Beispiel beim Fahren mit Gegenverkehr in der Dunkelheit oder bei Reflexionen von Sonnenlicht an einem vorausfahrenden Fahrzeug, deren korrekte Erfassung selbst das menschliche Auge vor Schwierigkeiten stellt. Ein Nachteil dieses Sensors ist, daß der Betrieb bei schwacher Inversion nur eine sehr geringe Photostromdichte der lichtempfindlichen Grenzfläche des Phototransistors liefert, und es deshalb zur Erzeugung von Photoströmen ausreichender Stärke und mit hinreichendem Signal-Rauschabstand notwendig ist, großflächige Phototransistoren einzusetzen. Dementsprechend gering ist die Ortsauflösung eines aus einer Anordnung solcher Lichtsensoren aufgebauten Lichtsensors.

Ein weiteres Problem, das sich aus der notwendigen großen Ausdehnung der lichtempfindlichen Grenzflächen ergibt, ist deren beträchtliche Kapazität. Je größer diese Kapazität ist, umso länger dauert es bei einer Änderung der Beleuchtungsstärke des Phototransistors, bis der entsprechend der Beleuchtungsänderung veränderte Photostrom zu einer Änderung des am Eingang des Sourcefolgers anliegenden Potentials und damit zu einer Änderung des von dem Lichtsensor gelieferten Meßsignals führt. Dieser Effekt ist unter der Bezeichnung "Nachzieheffekt" bekannt.

Bei Anwendungen im Automobilsektor sind jedoch schnelle Reaktionszeiten der Lichtsensoren erforderlich, denn um den Fahrer eines Kraftfahrzeugs beim Fahren wirksam unterstützen zu können, müssen solche Anwendungen, wie zum Beispiel ein automatischer Auffahrschutz beim Kolonnenfahren, eine kürzere Reaktionszeit als der Fahrer haben.

### Vorteile der Erfindung

Die genannten Probleme werden durch einen Lichtsensor gemäß Anspruch 1 gelöst.

Das erfindungsgemäß vorgesehene Rückkopplungsglied ermöglicht große Änderungen des Ausgangssignals des Lichtsensors bei relativ geringen beleuchtungsabhängigen Änderungen der Anschlußpotentiale des Phototransistors und infolgedessen bei relativ kleinen bei einer Beleuchtungsänderung im Phototransistor zu verschiebenden Ladungen. So wird gleichzeitig eine hohe Empfindlichkeit und eine hohe Reaktionsgeschwindigkeit des Lichtsensors erreicht.

Insbesondere, wenn gemäß der Erfindung die zweite Hauptelektrode des Phototransistors und seine Steuerelektrode nicht mehr wie bei dem bekannten Lichtsensor direkt an das Versorgungspotential angebunden sind, sondern über ein Rückkopplungsglied gekoppelt sind, ist es möglich, das Gatepotential des Phototransistors in Abhängigkeit vom Photostrom beziehungsweise der auf den Phototransistor treffenden Helligkeit zu variieren. Die dadurch modulierte Leitfähigkeit des Phototransistors führt bei geringen Schwankungen des Photostroms zu starken Änderungen des Potentials an der ersten Hauptelektrode des Phototransistors, die vom Impedanzwandler in ein außerhalb des Lichtsensors weiterverarbeitbares Signal umgesetzt werden.

Um eine logarithmische Charakteristik des Lichtsensors und damit seine Anwendbarkeit über mehrere Dekaden der Beleuchtungsstärke hinweg zu erzielen, wird der Phototransistor zweckmäßigerweise in schwacher Inversion betrieben.

Als Rückkopplungsglied dient ein Transistor, der zum Beispiel eine an die. zweite Hauptelektrode des Phototransistors angeschlossene Steuerelektrode, eine an die Steuerelektrode des Phototransistors angeschlossene erste Hauptelektrode und eine an ein erstes Versorgungspotential angeschlossene zweite Hauptelektrode hat. Auch dieser Transistor wird vorzugsweise in schwacher Inversion betrieben.

Als Impedanzwandler wird ein weiterer Transistor verwendet, der beispielsweise als Sourcefolger mit der ersten Hauptelektrode des Phototransistors verbunden ist.

Ein resistives Element, vorzugsweise ebenfalls ein Transistor, kann zwischen die zweite Hauptelektrode des Phototransistors und das erste Versorgungspotential geschaltet sein, um Veränderungen des an der Steuerelektrode des als Rückkopplungsglied dienenden Transistors anliegenden Potentials in Abhängigkeit vom Photostrom zu ermöglichen.

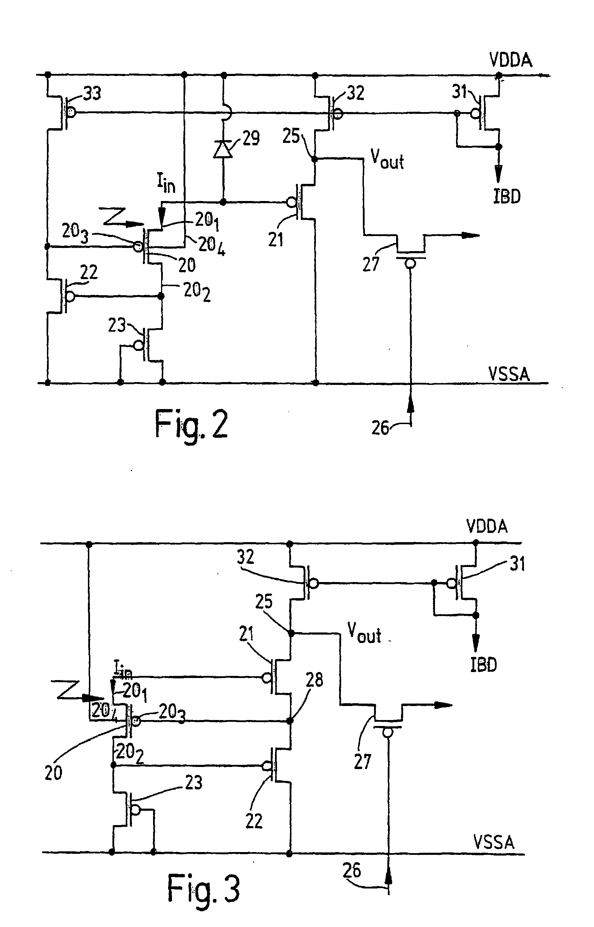

Ein in Sperrichtung betriebener Halbleiterübergang des Phototransistors bildet einen Stromweg zwischen dem ersten und einem zweiten Versorgungspotential. Dieser Halbleiterübergang kann beispielsweise der Übergang zwischen einer Bulkelektrode des Phototransistors und dessen Sourceelektrode sein. Gemäß einer einfachen Variante kann diese Bulkelektrode direkt an das erste Versorgungspotential (VDD in Figur 2) angeschlossen sein; eine zusätzlich verkürzte Reaktionszeit des Lichtsensors ergibt sich, wenn die Bulkelektrode mit dem Ausgang des Sourcefolger-Transistors verbunden ist.

Eine zusätzlich verstärkte Rückkopplung läßt sich erzielen, wenn die erste Hauptelektrode des das Rückkopplungsglied bildenden Transistors mit der zweiten Hauptelektrode des Sourcefolger-Transistors verbunden ist.

Weitere Merkmale und Vorteile der Erfindung ergeben sich aus der nachfolgenden Beschreibung von Ausführungsbeispielen mit Bezug auf die Figuren.

### Figuren

Es zeigen:
- Figur 1: ein Schnittbild eines im Rahmen der Erfindung verwendbaren Phototransistors in PMOS-Technologie;
- Figur 2 bis 5: Schaltskizzen von vier Ausführungsbeispielen von erfindungsgemäßen Helligkeitssensoren.

### Beschreibung der Ausführungsbeispiele

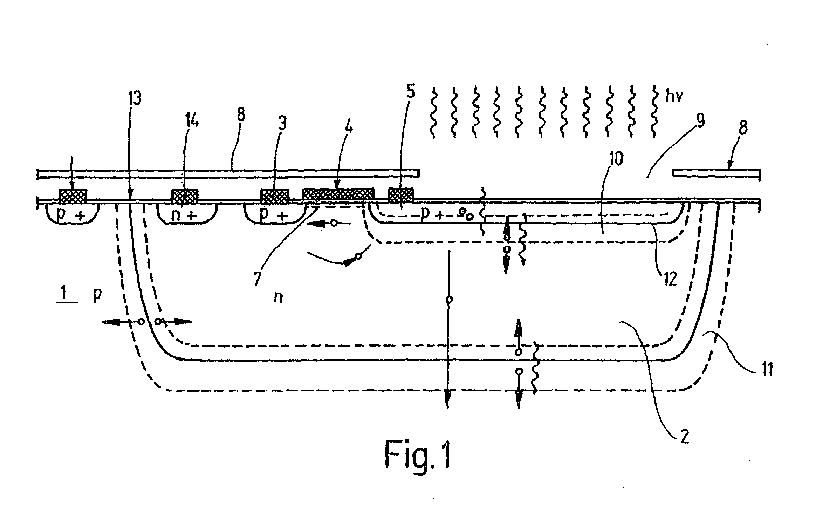

Figur 1 zeigt einen Schnitt durch ein p-leitendes Halbleitersubstrat 1, in dem eine n-Wanne 2 gebildet ist. Zwei p+-dotierte Bereiche an der Oberfläche der Wanne bilden die Hauptelektroden Drain 3 und Source 5 eines MOS-Phototransistors. Eine Steuer- oder Gateelektrode 4 überdeckt, durch eine Oxidschicht 6 isoliert, Ränder der p+-dotierten Bereiche von Drain und Source sowie die dazwischen liegende Kanalzone 7 der Wanne. Mit Ausnahme der Sourceelektrode 5 ist die Oberfläche der Wanne 2 und ihrer Umgebung durch eine lichtdichte Metallschicht 8 überdeckt.

Durch das Fenster 9 in das Halbleitermaterial eindringendes Licht bewirkt die Erzeugung von Elektronen-Loch-Paaren darin. In Raumladungsbereichen 10,11 beiderseits der pn-Grenzschichten 12,13 zwischen Source 5 und Wanne 2 beziehungsweise zwischen Wanne 2 und Substrat 1 werden die Ladungsträger durch das dort vorhandene elektrische Feld getrennt, und es entsteht ein Photostrom. Minoritätsladungsträger, die außerhalb der Raumladungszone generiert wurden, können durch Diffusion in eine der Raumladungszonen 10,11 gelangen. Die in die Raumladungszone 10 diffundierten Minoritätsladungsträger tragen ebenfalls zum Photostrom bei, während die in die Raumladungszone 11 diffundierten den Substrat/Bulk-Strom erhöhen, Über die beiden p-dotierten Gebiete, die Source 5 und das Substrat 1, werden so die Löcher gesammelt und abgeleitet, die Elektronen hingegen werden über die n-Wanne abgeführt. Hierzu kann die Bulkelektrode 14 dienen, die durch einen n+-dotierten Bereich an der Oberfläche der Wanne gebildet ist.

Figur 2 zeigt einen schematischen Schaltplan eines Lichtsensors nach einer ersten Ausgestaltung der Erfindung. Die Schaltung ist auf einem Halbleitersubstrat integriert, Kernbestandteil ist ein Phototransistor 20, der so wie in Figur 1 gezeigt aufgebaut sein kann. Eine erste Hauptelektrode 20₁ des Phototransistors ist über eine Halbleiter-Grenzschicht 29, die in dem Schaltplan als Diode dargestellt ist, mit einem Versorgungspotential VDDA verbunden. Die Grenzschicht 29 ist in Sperrichtung vorgespannt, und es fließt nur ein minimaler Strom. Abgesehen von diesem minimalen Strom kann die Hauptelektrode 20₁ als floating source aufgefaßt werden. Diese Grenzschicht 29 entspricht im wesentlichen der Grenzschicht 12 zwischen Source 5 und Wanne 2 des in Figur 1 gezeigten Phototransistors, von wo Elektronen durch die Wanne 2 und die Bulkelektrode 14 zum Versorgungspotential VDDA abfließen. Sie ist also in der Praxis Teil des Phototransistors 20 und ist deshalb in den Schaltskizzen der Figuren 3 bis 6, die einen Phototransistor 20 der gleichen Art enthalten, nicht mehr als eigenständiges Schaltungselement dargestellt.

Ein Transistor 23 ist zwischen die zweite Hauptelektrode 20₂ des Phototransistors 20 und ein Versorgungspotential VSSA geschaltet. Aufgabe des Transistors 23 ist, das Potential an der Hauptelektrode 20₂ vom Versorgungspotential VSSA zu entkoppeln, so daß ersteres in Abhängigkeit von der Stärke des durch den Phototransistor 20 fließenden Stroms Iᵢₙ variieren kann.

Die Steuerelektrode eines weiteren Transistors 22 ist an die Hauptelektrode 20₂ angeschlossen. Der Transistor 22 ist zusammen mit einem Regeltransistor 33 zwischen den zwei Versorgungspotentialen VDDA und VSSA in Reihe geschaltet. Die Steuerelektrode 20₃ des Phototransistors ist mit dem Mittenpunkt zwischen den Transistoren 22 und 33 verbunden.

Der Regeltransistor 33 ist mit Hilfe eines weiteren Regeltransistors 31 und eines Steuersignals IBD so angesteuert, daß das Potential an der Steuerelektrode 20₃ des Phototransistors stets niedrig genug ist, um einen Betrieb des Phototransistors 20 sowie der Transistoren 22 und 23 bei geringer Inversion zu gewährleisten.

Eine Verstärkung des Lichteinfalls auf den Phototransistor 20 führt zu einer Erhöhung von dessen Durchlässigkeit und damit zu einer Zunahme des hindurchfließenden Photostroms Iᵢₙ. Entsprechend nimmt der Spannungsabfall am Transistor 23 beziehungsweise das an der Steuerelektrode des Transistors 22 anliegende Potential zu. Infolgedessen verringert sich die Durchlässigkeit des Transistors 22, das an der Steuerelektrode 20₃ des Phototransistors anliegende Potential nimmt zu, und die Durchlässigkeit des Phototransistors 20 nimmt ab. Das infolgedessen ebenfalls zunehmende Potential an der Hauptelektrode 20₁ des Phototransistors 20 liegt gleichzeitig an der Steuerelektrode eines Sourcefolger-Transistors 21 an. Der Sourcefolger-Transistor 21 ist zusammen mit einem weiteren Regeltransistor 32 zwischen den Versorgungspotentialen VDDA und VSSA in Reihe geschaltet. Der Regeltransistor 32 ist in gleicher Weise wie der Regeltransistor 33 durch das Eingangssignal IBD gesteuert, ist allerdings so dimensioniert, daß der Sourcefolger-Transistor 21 nicht in schwacher Inversion arbeitet. Durch diese Schaltungsanordnung wird am Mittenpunkt 25 zwischen Sourcefolger-Transistor 21 und Regeltransistor 32 ein Potential mit geringem Innenwiderstand erhalten, das über mehrere Dekaden (bis zu 8) dem Logarithmus der vom Phototransistor 20 aufgenommenen Beleuchtungsstärke proportional ist. Dieses Potential Vₒᵤₜ wird über einen über eine Dekoderleitung 26 von außerhalb des Lichtsensors angesteuerten Schalttransistor 27 an eine (nicht dargestellte) Busleitung ausgegeben, an die eine Vielzahl gleich aufgebauter Lichtsensoren angeschlossen sein können.

Indem bei dieser Schaltung das an der zweiten Hauptelektrode 20₂ anstehende Potential über den Transistor 22 an die Steuerelektrode 20₃ des Phototransistors rückgekoppelt wird, wird eine erheblich stärkere Änderung des Eingangspotentials des Sourcefolger-Transistors 21 erzielt, als dies bei herkömmlichen, rückkopplungsfreien Helligkeitssensoren in CMOS-Technik möglich ist. Hinzu kommt, daß die einer Veränderung des Photostroms entgegenwirkende Rückkopplungsregelung an der Steuerelektrode 20₃ auch bei veränderlichen Helligkeitsverhältnissen zu geringen Änderungen der am Phototransistor selbst abfallenden Spannung führt. Schwankungen des Spannungsabfalls infolge von Helligkeitsänderungen finden im wesentlichen am Transistor 23 statt. Dies bedeutet, daß aufgrund der im Vergleich zum Phototransistor erheblich kleineren Abmessungen des Transistors 23 nur geringe Kapazitäten bei einer Helligkeitsänderung umgeladen werden müssen, damit das Ausgangssignal der Schaltung der veränderten Helligkeit folgen kann. So wird mit der Schaltung nicht nur die Empfindlichkeit des Helligkeitssensors erhöht, sondern auch seine Reaktionsgeschwindigkeit.

Figur 3 zeigt eine Variante der Schaltung aus Figur 2. Bei dieser Variante ist der Regeltransistor 33 entfallen; stattdessen ist der Transistor 22 mit der Anordnung aus Regeltransistor 32 und Sourcefolger-Transistor 21 in Reihe geschaltet, und die Steuerelektrode 20₃ des Phototransistors ist an den Mittenpunkt 28 zwischen den Transistoren 21 und 22 angeschlossen. Das Prinzip der Rückkopplung zwischen zweiter Hauptelektrode 20₂ und Steuerelektrode 20₃ des Phototransistors 20 mit Hilfe der Transistoren 23 und 22 ist das gleiche wie im Falle der Figur 2. Die Reihenschaltung der Transistoren 21 und 22 bewirkt darüber hinaus einen zweiten Rückkopplungsmechanismus. Wenn nämlich infolge zunehmender Helligkeit das Potential am Mittenpunkt 28 ansteigt, so führt diese Potentialerhöhung zusätzlich zur Ansteuerung des Sourcefolger-Transistors 21 über die erste Hauptelektrode des Phototransistors 20 zu einer Zunahme des Potentials Vₒᵤₜ am Punkt 25. So wird mit dem Schaltungsaufbau des Helligkeitssensors nach Figur 3 mit weniger Schaltungselementen (und dementsprechend geringerem Verbrauch an Halbleitersubstrat-Oberfläche) eine weiter vergrößerte Empfindlichkeit des Helligkeitssensors erreicht.

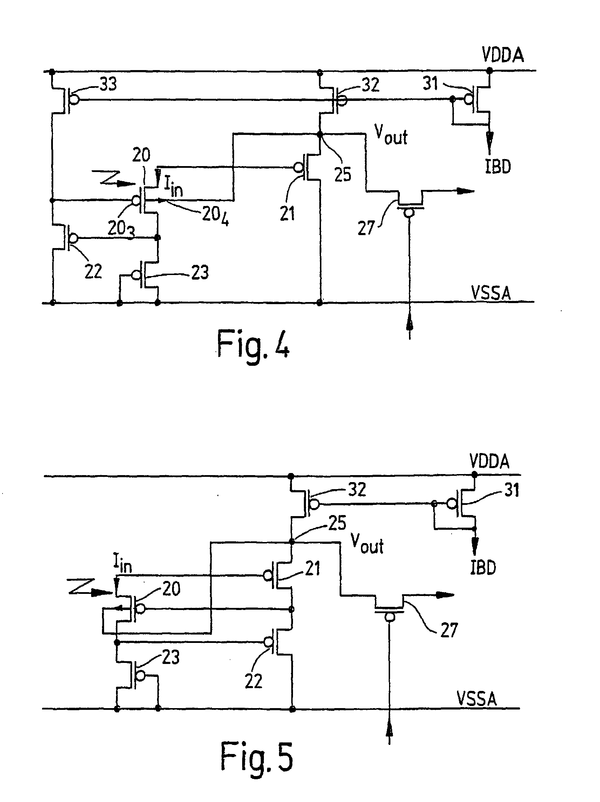

Figur 4 zeigt eine zweite Variante der Schaltung aus Figur 2, bei der ein zweiter Rückkopplungsmechanismus zum Einsatz kommt. Der Unterschied zu dem Lichtsensor aus Figur 2 liegt darin, daß hier die Bulkelektrode 20₄ des Phototransistors 20 an den Mittenpunkt 25 zwischen dem Regeltransistor 32 und dem Sourcefolger-Transistor 21 angeschlossen ist. Das Ausgangssignal Vₒᵤₜ des Lichtsensors wird auf diese Weise an die Bulkelektrode 20₄ rückgeführt und legt so das Potential der Wanne 2 (siehe Figur 1) des Phototransistors fest. Zur Erläuterung soll im folgenden das Versorgungspotential VDDA als positives Potential und das Versorgungspotential VSSA als Masse beziehungsweise Null angenommen werden. Dabei versteht sich, daß bei entsprechender Wahl der Leitfähigkeiten beziehungsweise Dotierungen der Transistoren auch andere Verhältnisse möglich sind.

Wenn an der Bulkelektrode 20₄ (beziehungsweise 14 in Figur 1) ein positives Potential anliegt, werden Elektronen aus der n-leitenden Wanne abgezogen, und es bilden sich an Ladungsträgern verarmte Zonen beiderseits der pn-Grenzschichten 12,13. Je höher das an der Bulkelektrode anliegende positive Potential ist, umso breiter ist diese verarmte Zone, und umso größere Ladungen müssen im Falle einer Änderung der Beleuchtungsstärke durch den Phototransistor fließen, bis ein neuer stationärer Zustand der Dicke der verarmten Zone und damit des Spannungsabfalls am Phototransistor erreicht ist. Dies wird bei der Variante nach Figur 4 dadurch vermieden, daß nicht ein festes Versorgungspotential an der Bulkelektrode anliegt, sondern das variable Ausgangspotential der Schaltung, das heißt die Spannungsdifferenz zwischen Source 5 und Wanne 2 des Phototransistors ist immer gleich der Spannungsdifferenz zwischen der mit dem Punkt 25 verbundenen ersten Hauptelektrode des Sourcefolger-Transistors und dessen Steuerelektrode 21. Der dadurch eingeschränkte Spannungshub zwischen Wanne und Source des Phototransistors ermöglicht abermals eine Verkürzung der Reaktionszeit des Phototransistors beziehungsweise eine Verbesserung des Nachzieheffekts um den Faktor 4.

Wie Figur 5 zeigt, lassen sich die in Figuren 3 und 4 vorgestellten Varianten miteinander kombinieren: Hier ist gleichzeitig die Reihenschaltung des Transistors 22 mit den Transistoren 32 und 21 und die Verbindung der Bulkelektrode des Phototransistors 20 mit dem Mittenpunkt 25 zwischen den Transistoren 21 und 32 realisiert. Diese Ausgestaltung vereint die erhöhte Empfindlichkeit und den einfachen Aufbau der Variante nach Figur 3 mit der kurzen Reaktionszeit der Variante nach Figur 4.

## Patentansprüche

1. Lichtsensor mit einem MOS-Fototransistor (20) und einem ersten Transistor (21) als Impedanzwandler für ein Potential einer ersten Hauptelektrode (20₁) des MOS-Fototransistors (20), wobei ein Rückkopplungsglied (22) ein Potential an einer zweiten Hauptelektrode (20₂) des MOS-Fototransistors an eine Steuerelektrode (20₃) des MOS-Fototransistors (20) rückkoppelt, **dadurch gekennzeichnet, daß** das Rückkopplungsglied ein zweiter Transistor (22) ist.

2. Lichtsensor nach Anspruch 1, **dadurch gekennzeichnet, daß** der Fototransistor (20) in schwacher Inversion betrieben wird.

3. Lichtsensor nach Anspruch 1 oder 2, **dadurch gekennzeichnet, daß** der zweite Transistor (22) in schwacher Inversion betrieben wird.

4. Lichtsensor nach einem der Ansprüche 1 bis 3, **dadurch gekennzeichnet, daß** der erste Transistor (21) als Source-Folger mit einer ersten Hauptelektrode (5, 20₁) des Fototransistors (20) verbunden ist.

5. Lichtsensor nach Anspruch 4, **dadurch gekennzeichnet, daß** die zweite Hauptelektrode (3, 20₂) des Fototransistors (20) über ein resistives Element mit einem ersten Versorgungspotential (VSSA) verbunden ist.

6. Lichtsensor nach Anspruch 5, **dadurch gekennzeichnet, daß** das resistive Element ein dritter Transistor (23) ist.

7. Lichtsensor nach einem der Ansprüche 4 bis 6, **dadurch gekennzeichnet, daß** die zweite Hauptelektrode des als Source-Folger geschalteten Transistors (21) direkt oder über das Rückkopplungsglied (22) mit einem ersten Versorgungspotential (VSSA) verbunden ist.

8. Lichtsensor nach einem der Ansprüche 1 bis 7, **dadurch gekennzeichnet, daß** der Fototransistor (20) eine mit einem zweiten Versorgungspotential (VDDA) verbundene Bulkelektrode (14, 20₄) hat.

9. Lichtsensor nach einem der Ansprüche 1 bis 7, **dadurch gekennzeichnet, daß** der Fototransistor (20) eine mit dem Ausgang des Source-Folger-Transistors (21) verbundene Bulkelektrode (14, 20₄) hat.

10. Lichtsensor nach einem der vorhergehenden Ansprüche, **dadurch gekennzeichnet, daß** die erste Hauptelektrode des zweiten Transistors (22) mit der zweiten Hauptelektrode des Source-Folger-Transistors (21) verbunden ist.

## Claims

1. Light sensor having a MOS phototransistor (20) and a first transistor (21) as impedance converter for a potential of a first main electrode (20₁) of the MOS phototransistor (20), a feedback element (22) feeding back a potential at a second main electrode (20₂) of the MOS phototransistor to a control electrode (20₃) of the MOS phototransistor (20), **characterized in that** the feedback element is a second transistor (22).

2. Light sensor according to Claim 1, **characterized in that** the phototransistor (20) is operated in weak inversion.

3. Light sensor according to Claim 1 or 2, **characterized in that** the second transistor (22) is operated in weak inversion.

4. Light sensor according to one of Claims 1 to 3, **characterized in that** the first transistor (21) is connected as source follower to a first main electrode (5, 20₁) of the phototransistor (20).

5. Light sensor according to Claim 4, **characterized in that** the second main electrode (3, 20₂) of the phototransistor (20) is connected to a first supply potential (VSSA) via a resistive element.

6. Light sensor according to Claim 5, **characterized in that** the resistive element is a third transistor (23).

7. Light sensor according to one of Claims 4 to 6, **characterized in that** the second main electrode of the transistor (21) connected as source follower is connected to a first supply potential (VSSA) directly or via the feedback element (22).

8. Light sensor according to one of Claims 1 to 7, **characterized in that** the phototransistor (20) has a bulk electrode (14, 20₄) connected to a second supply potential (VDDA).

9. Light sensor according to one of Claims 1 to 7, **characterized in that** the phototransistor (20) has a bulk electrode (14, 20₄) connected to the output of the source follower transistor (21).

10. Light sensor according to one of the preceding claims, **characterized in that** the first main electrode of the second transistor (22) is connected to the second main electrode of the source follower transistor (21).

## Revendications

1. Capteur de lumière avec un phototransistor MOS (20) et un premier transistor (21) comme adaptateur d'impédance pour un potentiel d'une première électrode principale (20₁) du phototransistor MOS (20), dans lequel un organe de réaction (22) couple rétroactivement un potentiel sur une seconde électrode principale (20₂) du phototransistor MOS à une électrode de commande (20₃) du phototransistor (20),
**caractérisé en ce que**
l'organe de réaction est un deuxième transistor (22).

2. Capteur de lumière selon la revendication 1,
**caractérisé en ce que**
le phototransistor (20) fonctionne en inversion faible.

3. Capteur de lumière selon la revendication 1 ou 2,
**caractérisé en ce que**
le deuxième transistor (22) fonctionne en inversion faible.

4. Capteur de lumière selon l'une quelconque des revendications 1 à 3,
**caractérisé en ce que**
le premier transistor (21) est raccordé en suiveur de source à une première électrode principale (5, 20₁) du phototransistor (20).

5. Capteur de lumière selon la revendication 4,
**caractérisé en ce que**
la seconde électrode principale (3, 20₂) du phototransistor (20) est raccordée à un premier potentiel d'alimentation (VSSA) par l'intermédiaire d'un élément résistif.

6. Capteur de lumière selon la revendication 5,
**caractérisé en ce que**
l'élément résistif est un troisième transistor (23).

7. Capteur de lumière selon l'une quelconque des revendications 4 à 6,
**caractérisé en ce que**
la seconde électrode principale du transistor (21) raccordé en suiveur de source est raccordée à un premier potentiel d'alimentation (VSSA) directement ou par l'intermédiaire de l'organe de réaction (22).

8. Capteur de lumière selon l'une quelconque des revendications 1 à 7,
**caractérisé en ce que**
le phototransistor (20) comporte une électrode massive (14, 20₄) raccordée à un second potentiel d'alimentation (VDDA).

9. Capteur de lumière selon l'une quelconque des revendications 1 à 7,
**caractérisé en ce que**
le phototransistor (20) comporte une électrode massive (14, 20₄) raccordée à la sortie du transistor suiveur de source (21).

10. Capteur de lumière selon l'une quelconque des revendications précédentes,
**caractérisé en ce que** la première électrode principale du deuxième transistor (22) est raccordée à la seconde électrode principale du transistor suiveur de source (21).
